# EUROPÄISCHE PATENTSCHRIFT

(11) **EP 1 088 319 B1**
(45) Veröffentlichungstag und Bekanntmachung des Hinweises auf die Patenterteilung: **10.12.2003**
(21) Anmeldenummer: 99936378.1
(22) Anmeldetag: 01.06.1999
(51) Int. Cl.: H01J 1/00

(54) **VORRICHTUNG ZUR FORMUNG EINES ELEKTRONENSTRAHLS, VERFAHREN ZUR HERSTELLUNG DER VORRICHTUNG UND ANWENDUNG**
DEVICE FOR SHAPING AN ELECTRON BEAM, METHOD FOR PRODUCING SAID DEVICE AND USE THEREOF
DISPOSITIF POUR LA FORMATION D'UN FAISCEAU D'ELECTRONS, PROCEDE POUR LA FABRICATION DU DISPOSITIF ET UTILISATION

(30) Priorität: 03.06.1998 DE 19824783
(43) Veröffentlichungstag der Anmeldung: 04.04.2001
(73) Patentinhaber: SIEMENS AKTIENGESELLSCHAFT, 80333 München (DE)
(72) Erfinder: BURKHARDT, Klaus, D-76703 Kraichtal (DE); ECKHARDT, Wolfgang, D-76229 Karlsruhe (DE); GOHLKE, Silvia, D-81543 München (DE); MÄNNER, Ruth, D-85667 Oberpframmern (DE); WERSING, Wolfram, D-81667 München (DE)
(86) Internationale Anmeldenummer: DE9901610
(87) Internationale Veröffentlichungsnummer: WO99063566

(56) Entgegenhaltungen:
- EP-A- 0 388 980
- DD-A- 275 156
- DE-A- 3 837 300
- DE-A- 19 646 369
- DE-C- 4 419 764
- US-A- 5 367 218
- US-A- 5 443 786
- US-A- 5 534 743
- US-A- 5 661 363
- R.BAUER ET AL: "Realization of LTCC-Multilayer with Special Cavity Applications" SPIE, PROC.1997 INT. SYMP ON MICROELECTRONICS, Bd. 3235, 14. - 16. Oktober 1997, Seiten 659-664, XP002122488 Philadelphia

## Beschreibung

In der Technik finden Elektronenröhren vielfach Anwendung, so z.B. in Elektronenmikroskopen oder Monitoren. Ziel vieler Entwicklungen auf dem Gebiet der Elektronenröhren ist die Verbesserung des Auflösungsvermögens der Geräte, in denen diese Röhren eingesetzt werden. Das Auflösungsvermögen eines solchen Geräts hängt unter anderem von der Elektronenkanone ab, die in der Elektronenröhre des Geräts integriert ist. Die Elektronenkanone erzeugt einen Elektronenstrahl. Sie umfaßt eine Elektronenquelle und eine geeignete Anordnung von Elektroden. Als Elektronenquelle kommt beispielsweise eine geheizte Kathode in Frage, die durch thermische Energie angeregte Elektronen emittiert. Die Elektroden dienen als Blenden der Fokussierung, der Intensitätsmodulierung und gegebenenfalls der Ablenkung des Elektronenstrahls.

Nach dem heutigen Stand der Technik enthalten Elektronenkanonen hochauflösender Monitore folgenden Aufbau: Die Kathode und eine erste Gitterelektrode sind in einem Metalltopf zusammengefaßt, der in eine Glashalterung der Elektronenröhre eingeschmolzen ist. In Ausbreitungsrichtung des Elektronenstrahls sind zwei weitere Gitterelektroden angebracht, die ebenfalls in die Glashalterung eingeschmolzen sind.

Um eine sehr hohe Auflösung des Monitors zu erreichen, müssen die sehr feinen Durchtrittsöffnungen der Gitterelektroden bzw. Elektrodenbleche zur Elektronenfokussierung exakt kreisrund und koaxial zueinander angeordnet sein. Darüber hinaus ist ein extrem kapazitätsarmer Aufbau der Elektrodenanordnung eine Grundvoraussetzung zur Erzielung einer hohen Signalbandbreite.

Diese Anforderungen werden von der konventionellen Röhrentechnik bisher nicht zufriedenstellend erfüllt. Beispielsweise ist die koaxiale Ausrichtung der Durchtrittsöffnungen für den Elektronenstrahl durch das getrennte Einschmelzen der Elektroden in Glas nur eingeschränkt möglich.

Eine dazu alternative Lösung geht aus der US-A-5 661 363 hervor. Die daraus bekannte Vorrichtung zur Formung eines Elektronenstrahls ist ein keramischer Körper in monolithischer Vielschichtbauweise mit mindestens einer Elektrodenkeramiklage, die mindestens eine Durchtrittsöffnung für den Elektronenstrahl aufweist. Die Elektrodenkeramiklage besteht aus Rutheniumoxid, einem elektrisch leitfähigen, keramischen Material. Die Elektrodenkeramiklage selbst ist dabei eine Elektrode, mit deren Hilfe der Elektronenstrahl geformt werden kann. In einer Ausführungsform sind mehrere Elektrodenkeramiklagen und Isolierkeramiklagen zur elektrischen Isolierung der Elektrodenkeramiklagen in Ausbreitungsrichtung des Elektronenstrahls alternierend angeordnet.

Aufgabe der Erfindung ist es, eine kapazitätsarme Vorrichtung zur Formung eines Elektronenstrahls und ein Verfahren zu deren Herstellung anzugeben.

Diese Aufgabe wird von den Merkmalen der Anspruchs 1 der Erfindung gelöst. Besondere Ausgestaltungen der erfindungsgemäßen Vorrichtung sind den Ansprüchen 2 bis 7 zu entnehmen.

Nach Anspruch 1 wird eine Vorrichtung zur Formung eines Elektronenstrahls, bestehend aus einem keramischen Körper in monolithischer Vielschichtaufbauweise angegeben mit mindestens zwei Elektrodenkeramiklagen, die jeweils mindestens eine Durchtrittsöffnung für den Elektronenstrahl und jeweils mindestens eine an der Durchtrittsöffnung angeordnete Elektrode mit elektrischer Kontaktierung aufweisen, und mindestens einer Isolierkeramiklage, die eine Durchtrittsöffnung für den Elektronenstrahl aufweist und die zur Isolierung der Elektrodenkeramiklagen zwischen den Elektrodenkeramiklagen angeordnet ist, wobei die Elektrodenkeramiklagen und die Isolierkeramiklage entlang einer Ausbreitungsrichtung des Elektronenstrahls derart angeordnet sind, daß die Durchtrittsöffnungen der Elektrodenkeramiklagen und der Isolierkeramiklage eine gemeinsame Durchtrittsöffnung bilden. Die Vorrichtung ist dadurch gekennzeichnet, daß die Elektrodenkeramiklagen und die Isolierkeramiklage eine Glaskeramik mit einer aus dem Bereich von einschließlich 6 bis einschließlich 8 ausgewählten relativen Dielektrizitätskonstante aufweisen, die Elektroden um die Durchtrittsöffnung angeordnete Ringelektroden sind und die Elektroden und die elektrischen Kontaktierungen der Elektrodenkeramiklagen aus einem elementaren Metall sind.

Diese Vorrichtung, die im folgenden auch als Elektrodenanordnung bezeichnet wird, umfaßt beispielsweise drei Elektroden und dient in einer Elektronenkanone der Fokussierung des Elektronenstrahls.

Der Keramikkörper ist vorzugsweise als flacher, runder Zylinder geformt und hat mindestens eine Durchtrittsöffnung, durch die der Elektronenstrahl geführt werden kann.

Die Elektrodenanordnung ist monolithisch aus mehreren Keramiklagen aufgebaut. Die einzelnen Keramiklagen sind vorzugsweise unterschiedlich aufgebaut und übernehmen damit auch unterschiedliche Funktionen. Elektrodenkeramiklagen weisen Elektroden mit zugehörigen elektrischen Kontaktierungen beispielsweise in Form von Leiterbahnen auf. Die Elektroden sind dabei an der Durchtrittsöffnung vorzugsweise an der Oberfläche der Elektrodenkeramiklage angebracht. Isolierkeramiklagen dienen dazu, Elektrodenkeramiklagen von einander zu isolieren und in einem definierten Abstand zueinander anzuordnen. Elektrodenkeramiklagen und Isolierkeramiklagen sind in Ausbreitungsrichtung des Elektronenstrahls vorzugsweise alternierend angeordnet.

Die elektrischen Kontaktierungen ermöglichen das Festlegen des Potentials der Elektroden. Die Leiterbahnen sind vorzugsweise im Inneren des keramischen Körpers angeordnet.

Jede der Durchtrittsöffnungen der Elektrodenkeramiklagen ist insbesondere exakt kreisrund. Jede Elektrode ist vorzugsweise als ein Ring aus elektrisch leitendem Material geformt. Besonders vorteilhaft ist es, wenn der Ring geschlossen ist. Er kann aber auch in einzelne Elektroden unterteilt sein. Der innere Durchmesser des Rings entspricht vorzugsweise dem Durchmesser der Durchtrittsöffnung der Keramik an der entsprechenden Stelle. Diese Durchmesser können aber auch voneinander abweichen. Insbesondere können Abweichungen von einer exakt kreisrunden Form dann gewünscht sein, wenn Verzerrungen des Elektronenstrahls kompensiert werden, die sich bei der Elektronenstrahlerzeugung aus dem Gesamtaufbau der Elektronenröhre ergeben. Beispielsweise können die Durchtrittsöffnung und der Elektrodenring einer Elektrodenkeramiklage elliptisch geformt sein.

Die angesprochene Kompensation von Verzerrungen gelingt beispielsweise auch dadurch, daß an zwei oder mehreren Elektroden eines unterteilten Elektrodenrings einer Elektrodenkeramiklage, unterschiedliches Potential angelegt wird.

Als keramisches Material kommt vor allem niedrig sinternde Glaskeramik in Frage, die beispielsweise Aluminiumoxid, Boroxid oder Erdalkalioxide enthält. Die Zusammensetzung der Glaskeramik ist dabei so gewählt, daß sich die Keramik im Temperaturbereich des Schmelzpunkts des verwendeten Metalls verdichtet. Um erfindungsgemäß einen möglichst kapazitätsarmen Aufbau der Elektrodenanordnung zu erreichen, muß darüber hinaus das Material des Keramikkörpers eine möglichst niedrige relative Dielektrizitätskonstante aufweisen (6 ≤ εᵣ ≤ 8).

Die Elektroden und die Kontaktierungen bestehen aus Molybdän, Palladium, Platin, Silber oder Wolfram. Andere Metalle wie Kupfer oder Gold sind genauso möglich wie Legierungen der genannten Metalle wie beispielsweise Silber/Palladium. Die Leiterbahnen bestehen vorzugsweise aus dem gleichen Material wie die Elektroden. Unterschiedliches Material ist aber auch denkbar.

Besonders vorteilhaft ist es, wenn eine Elektrodenkeramiklage mehrere Elektroden hat, die in Ausbreitungsrichtung des Elektronenstrahls nacheinander angeordnet sind. Diese Elektroden können elektrisch leitend miteinander verbunden sein. Insbesondere können die Elektroden auch elektrisch voneinander isoliert sein. Dadurch können im Elektronenstrahlerzeugungsprozeß an den Elektroden unterschiedliche Potentiale angelegt werden. Eine solche Anordnung ersetzt den Wunsch der klassischen Röhrentechnik, konische Durchtrittsöffnungen zur Fokussierung und Intensitätsmodulierung des Elektronenstrahls zu benutzen.

Die Elektrodenanordnung kann mehrere Durchtrittsöffnungen aufweisen, durch die jeweils ein Elektronenstrahl geführt wird. Eine derartige Anordnung wird beispielsweise in Farbbildröhren mit drei Strahlsystemen benutzt. Für jede der drei Grundfarben (z.B. blau, gelb, rot) wird ein eigener Elektronenstrahl erzeugt.

Für die Anwendung in Elektronenröhren ist es besonders vorteilhaft, wenn die Elektrodenanordnung über elektrische Kontaktierungen in Form von Durchkontaktierungen verfügt. Eine elektrische Durchkontaktierung durchdringt z.B. eine oder mehrere Keramiklagen. Über eine elektrische Durchkontaktierung sind beispielsweise zwei Elektroden einer Elektrodenkeramiklage elektrisch leitend miteinander verbunden.

Mittels elektrischer Anschlußstellen, die an der Oberfläche des Keramikkörpers angeordnet und die über Leiterbahnen und/oder Durchkontaktierungen mit den Elektroden verbunden sind, werden beispielsweise die Elektrodenpotentiale festgelegt.

Insbesondere vorteilhaft ist es, wenn die elektrischen Durchkontaktierungen, Leiterbahnen und Anschlüsse in und/oder an der Elektrodenanordnung so angeordnet sind, daß ein möglichst kapazitätsarmer Aufbau resultiert. Das bedeutet, daß die elektrische Kontaktierungen, die mit unterschiedlichem Potentialen gespeist werden, möglichst entkoppelt sind.

Mit Hilfe von elektrischen Anschlußstellen und/oder Kontaktierungen lassen sich in der keramischen Elektrodenanordnung besonders einfach zusätzliche Steuerfunktionen einer Elektronenkanone integrieren. Beispielsweise kann die Ansteuerung der Kathode über solche elektrischen Verbindungen erfolgen. Besonders vorteilhaft ist es, wenn in diesem Fall die Kathode beispielsweise über einen Keramiksockel mit Glaslot mit der Elektrodenanordnung verbunden ist. Dadurch werden zusätzliche Löcher und Leitungen im Gehäuse der Kathode überflüssig. Die Herstellung einer Elektronenkanone vereinfacht sich dadurch erheblich. Außerdem werden mögliche Lecks vermieden, die die Evakuierung der Elektronenröhre beeinträchtigen könnten.

Eine hier beschriebene Elektrodenanordnung kann in einer Elektronenkanone in herkömmlicher Weise durch Einschmelzen in Glas eingebaut sein. Sie dient der Intensitätsmodulierung und Fokussierung des Elektronenstrahls. Besonders vorteilhaft ist es, wenn die Elektrodenanordnung, wie oben beschrieben, direkt mit der Elektronenquelle verbunden ist.

Zusätzlich können weitere Bauteile einer Elektronenröhre über Glaslot mit der Elektrodenanordnung verbunden sein, wie beispielsweise die Hauptlinse einer Elektronenröhre.

Die Herstellung einer beschriebenen Elektrodenanordnung in monolithischer Vielschichtbauweise erfolgt vorzugsweise in der LTCC(low temperature cofired ceramic)- Technologie. Diese Technologie eignet sich zur Herstellung monolithischer keramischer Mehrschichtsysteme mit integrierten passiven Bauelementen (siehe z.B. D.L. Wilcox, Proc. 1997 ISHM Philadelphia, S. 17-23). Diese Technologie ist besonders für keramische Bauteile geeignet, in die elektrisch sehr gut leitendes Material wie Gold, Kupfer oder Silber integriert werden soll.

Die wesentlichen Verfahrensschritte der LTCC-Technologie sind:
- Herstellung einer einen organischen Binder enthaltenden Keramikgrünfolie, die Glaskeramik aufweist.
- Erzeugen von Öffnungen in der Keramikgrünfolie, die für Kontaktierungen gedacht sind.
- Befüllen der Öffnungen mit elektrisch leitendem Material.
- Bedrucken der Keramikgrünfolie mit elektrischen Leiterstrukturen.
- Übereinanderstapeln und Laminieren der Keramikgrünfolien zu einem Verbund.
- Sintern des Verbunds zu einem Körper mit monolithischen Vielschichtaufbau.

Durch das Verdichten des keramischen Materials beim Sintervorgang tritt ein Volurnenschwund von 10-20% auf. Würde man die LTCC-Technologie oder ein ähnliches Verfahren in bekannter Weise zur Herstellung einer Elektrodenanordnung einsetzen, müßte man vor allen Dingen laterale Toleranzen in Kauf nehmen, die im Hinblick auf die Forderungen an einen hochauflösenden Monitor inakzeptabel sind. Deshalb wird das LTCC-Verfahren modifiziert.

In der Herstellung der Elektrodenanordnung werden dabei vorgesinterte Keramiklagen übereinandergestapelt und zusammengesintert. Das Vorsintern erfolgt bei einer Temperatur, die unter der Sintertemperatur des verwendeten keramischen Materials liegt. Der Schwindungsprozeß der Keramik ist nach dem Vorsintern nahezu abgeschlossen. Dadurch wird der Einfluß des Schwindens der Keramik auf die auftretenden Toleranzen unterdrückt.

Durch diese Modifizierung der LTCC-Technologie lassen sich Längentoleranzen der Elektrodenabmessungen von ± 5µm erreichen. Darüber hinaus wird die koaxiale Ausrichtung der Gitter erheblich verbessert. Mit Hilfe dieser Technik läßt sich aber vor allen Dingen ein extrem kapazitätsarmer Aufbau der Fokussierungseinheit von bis zu 1pF verwirklichen.

Neben diesen Vorteilen gegenüber dem Stand der Technik stellt die Erfindung mit dem Verfahren auf der Basis der LTCC-Technologie ein kostengünstiges, leicht modifizierbares und automatisierbares Herstellungsverfahren der keramischen Elektrodenanordnung vor. Die LTCC-Technologie kann sehr leicht im Nutzen (multi up) angewendet werden.

Die Herstellung einer Keramikgrünfolie erfolgt nach bekannten Verfahren. Durch Schneiden oder Stanzen wird die Keramikgrünfolie auf die gewünschte Form zugeschnitten, die beispielsweise direkt die Form der Elektrodenanordnung sein kann, wie sie z.B. in einer Elektronenröhre verwendet wird. Oder es wird eine Form gewählt, die auf die Weiterverarbeitung der Keramikgrünfolie zugeschnitten ist (beispielsweise im Nutzen).

Die Öffnungen bzw. Löcher in der Keramikgrünfolie werden besonders einfach durch Stanzen erzeugt. Andere Verfahren zur Strukturierung von Keramikgrünfolien wie beispielsweise Photolithograpie oder das Erzeugen von Öffnungen mit Hilfe von Laserstrahlung können hier genauso angewendet werden.

Im Hinblick auf die Elektrodenanordnung wird in der Keramikgrünfolie mindestens eine Durchtrittsöffnung erzeugt, durch die im Elektronenstrahlerzeugungsprozeß der Elektronenstrahl geleitet wird. Mehrere solcher Durchtrittsöffnungen kommen dann in Frage, wenn mit Hilfe der Elektrodenanordnung mehrere Elektronenstrahlen manipuliert werden sollen (beispielsweise in Elektronenröhren von Farbmonitoren).

Neben dieser Durchtrittsöffnung, die in jeder Keramikgrünfolie auftritt, werden zusätzliche Löcher erzeugt. Diese werden nach den spezifischen Funktionen ausgewählt, die mit der entsprechenden Keramikgrünfolie in die Elektrodenanordnung integriert werden sollen. Soll beispielsweise eine vertikale elektrische Durchkontaktierung durch eine Keramiklage erzeugt werden, erhalten alle Keramikgrünfolien, die für die Herstellung der Keramiklage übereinander gestapelt werden, an der gleichen Position ein Loch. Dieses Loch wird in einem weiteren Verfahrensschritt mit Metall befüllt. Dabei bietet sich besonders das Schablonendruckverfahren an.

Neben den genannten Öffnungen, auf denen die Funktionalität der Elektrodenanordnung beruht, ist es besonders vorteilhaft, zusätzliche Löcher in den Keramikgrünfolien zu erzeugen, mit deren Hilfe die Herstellung der Elektrodenanordnung stark vereinfacht wird. So ermöglichen z.B. Zentrierlöcher im Herstellungsprozeß ein exaktes Übereinanderstapeln der Keramikgrünfolien. Besonders vorteilhaft ist es, in den Keramikgrünfolien Lochstrukturen zu erzeugen, die der Form der herzustellenden Elektrodenanordnung entsprechen. Mit Hilfe dieser Löcher können einzelne vorgesinterte Keramiklagen oder die vollständig gesinterte Elektrodenanordnung leicht vereinzelt werden.

Nach dem Erzeugen der Löcher wird zur Herstellung der Elektroden und Leiterbahnen elektrisch leitendes Material auf die Oberfläche der Keramikgrünfolie aufgetragen, wobei Elektrodenkeramikgrünfolien entstehen. Besonders vorteilhaft ist hier das Siebdruckverfahren anzuwenden. Andere Verfahren wie beispielsweise Schablonendruck sind ebenfalls denkbar. Dabei wird für die Elektrode eine Metallpaste an der Durchtrittsöffnung für den Elektronenstrahl angebracht. Besonders vorteilhaft ist es, die Elektrode als Ring zu formen, so daß die Öffnung und die innere Aussparung des Rings übereinander angeordnet sind. Der äußere Durchmesser des Rings ist so klein wie möglich gewählt, um eine möglichst kapazitätsarme Anordnung zu erhalten. Es ist besonders vorteilhaft, an der Oberund Unterseite der Keramikgrünfolie jeweils eine Elektrode anzubringen. Im Verlauf des Herstellungsverfahrens können die beiden Elektroden elektrisch leiten verbunden werden, oder voneinander isoliert bleiben.

Die Elektroden werden durch das Anbringen von Leiterbahnen beispielsweise mit elektrischen Durchkontaktierungen verbunden. Eine elektrische Verbindung von einer Elektrode zu einer Durchkontaktierung kann aber auch erst dann erfolgen, wenn eine Keramikgrünfolie mit einer Ringelektrode und eine Keramikfolie mit einer aufgedruckten Leiterbahn übereinandergestapelt und laminiert werden.

Im Gegensatz zur herkömmlichen LTCC-Technologie, bei der alle benötigten Keramikgrünfolien gemeinsam laminiert und gesintert werden, werden hier die Keramikgrünfolien zu kleineren Verbunden übereinandergestapelt, laminiert, vom organischen Binder befreit und zu einzelnen Keramiklagen gesintert. Das Sintern erfolgt bei einer Temperatur, die unter der Sintertemperatur Tₛ des verwendeten keramischen Materials liegt. Die Temperaturdifferenz beträgt beispielsweise 100 K. Im zweiten Schritt werden die vorgesinterten Keramiklagen, in die vorzugsweise unterschiedliche Funktionen integriert sind, übereinandergestapelt und unter Druck bei der Sintertemperatur Tₛ der Keramik nachgesintert. Der Druck, der beispielsweise durch Gewichtsbelastung erzeugt wird, ermöglicht ein planes Zusammenwachsen der Keramiklagen.

Die entscheidende Modifizierung der LTCC-Technologie ist die Aufteilung des Sinterns in zwei Sinterprozesse. Nach dem Vorsintern ist das Schwinden der Keramik nahezu abgeschlossen. Im zweiten Sintervorgang findet demnach kaum mehr eine Verdichtung der Keramik statt. Dadurch treten beim zweiten Sintervorgang kaum noch Verzerrungen der Elektrodenanordnung auf, die auf unterschiedliches Verdichten der Keramik zurückzuführen wären.

Zusätzlich zu der angegebenen Möglichkeit können diese Verzerrungen durch die Anwendung einer Sintertechnik unterdrückt werden, die den lateralen Schwund einer Keramik beim Sintern unterbindet. Dabei werden beispielsweise Keramikgrünfolien zusammengesintert, die unterschiedliches Keramikmaterial aufweisen. Besonders vorteilhaft ist es, wenn die oberste und die unterste Grünfolie eines laminierten Grünfolienstapels ein Keramikmaterial enthalten, das eine höhere Sintertemperatur aufweist, als das der Grünfolien im Inneren des Stapels. Der laminierte Stapel wird bei der Sintertemperatur des inneren Keramikmaterials gesintert, so daß nur dieses Material verdichtet. Das nicht verdichtende äußere Keramikmaterial verhindert den lateralen Schwund des inneren Keramikmaterials. Die Verdichtung des inneren Keramikmaterials findet nur senkrecht zu den Folienebenen statt. Als Beispiels für das Keramikmaterial der äußeren Keramikgrünfolien ist Aluminiumoxid zu nennen.

Eine weitere Möglichkeit, lateralen Schwund zu verhindern besteht darin, durch einachsigem Druck eine orientierte Verdichtung der Keramik zu erzwingen.

Nach dem Sintervorgang müssen unter Umständen die Keramiklagen nachbearbeitet werden. Durch Abschleifen und/oder Polieren der Oberflächen werden Keramiklagen erhalten, die definierte Schichtdicken und exakt ebene Flächen aufweisen. Dies ist vor allem im Hinblick auf die koaxiale Ausrichtung der Durchtrittsöffnungen für den Elektronenstrahl wichtig.

Das Abschleifen und/oder Polieren ist vor allem dann nötig, wenn die angesprochene Sintertechnik mit den Grünfolien, die unterschiedliches Keramikmaterial enthalten, angewendet wird. Das äußere Keramikmaterial muß vor dem Übereinanderstapeln der Keramiklagen von den Oberflächen der Keramiklagen entfernt werden.

Wenn die Oberflächen der vorgesinterten Keramiklagen abgeschliffen werden, so muß je nach Funktionsweise der Keramiklage elektrisch leitendes Material nach dem Abschleifen auf die Keramiklagen aufgebracht werden.

Die Durchtrittsöffnungen selbst müssen unter Umständen ebenfalls nachbearbeitet werden, um die vorgeschriebenen Toleranzen der Elektrodenabmessungen einzuhalten. Die Nachbearbeitung erfolgt vorzugsweise mechanisch (z.B. durch Schleifen und Laserbohren). Andere Verfahren wie beispielsweise Photolithographie oder Materialabtragung mittels Laserstrahl können hier ebenfalls eingesetzt werden.

Das Stapeln der Keramikgrünfolien und der Keramiklagen erfolgt günstigerweise in einer jeweiligen Stapelvorrichtung. Die Stapelvorrichtung ist beispielsweise so geformt, daß die Folien bzw. Lagen paßgenau in der Vorrichtung angeordnet werden können. Besonders vorteilhaft ist es, wenn die Vorrichtung entsprechend den Zentrierlöchern der keramischen Körper über Zentrierstifte verfügt. Mit Hilfe der Zentrierlöcher und -stifte können die Keramikgrünfolien bzw. Keramiklagen exakt übereinander gestapelt werden. Außerdem wird dadurch vermieden, daß einzelne Schichten während der Verarbeitung seitlich verrutschen. Das Sintern exakt übereinander gestapelter Keramikgrünfolien bzw. Keramiklagen ist für die koaxiale Ausrichtung der Elektroden von entscheidender Bedeutung.

Das Material, aus dem die Stapelvorrichtungen bestehen, ist so ausgewählt, daß keine Haftung zwischen Vorrichtung und Glaskeramik entsteht. Darüber hinaus muß das Material einen hohen Wärmeleitfähigkeitskoeffizienten aufweisen, damit kein Temperaturgradient im Verlauf des Sinterns auftritt. Besonders geeignet ist für die Anwendung Siliziumkarbid. Andere Materialien wie beispielsweise Zirkonoxid sind ebenfalls denkbar.

Ein besonderer Vorteil ergibt sich dadurch, daß die LTCC-Technologie leicht im Nutzen angewendet werden kann. Das bedeutet, daß in einer Keramikgrünfolie mehrere identische Strukturen erzeugt werden (z.B. 2x2). Für die Weiterverarbeitung gibt es verschiedene Möglichkeiten: Nach dem Laminieren der Keramikgrünfoliennutzen wird der Gesamtstapel beispielsweise durch Schneiden in einzelne identische Unterstapel zerteilt, die danach voneinander separiert gesintert werden. Alternativ dazu kann der laminierte Keramikgrünfoliennutzen entbindert und gesintert werden, wobei die Unterstapel nach dem Sintern beispielsweise durch Sägen voneinander getrennt werden.

Im Hinblick auf die Herstellung der Elektrodenanordnung ist folgendes Vorgehen besonders vorteilhaft: Im Verfahrensschritt der Löchererzeugung werden zusätzliche Lochstrukturen in der Keramikgrünfolie erzeugt. Diese Lochstrukturen sind beispielsweise quadratisch auf der Keramikgrünfolie angeordnet. Im Inneren eines jeden Quadrats befinden sich die oben beschriebenen Löcher bzw. Lochstrukturen.

Die Keramikgrünfoliennutzen werden wie oben beschrieben zu einem Nutzen aus Keramiklagen vorgesintert. Durch die Lochstrukturen ist es möglich, die Keramiklagen beispielsweise durch Herausbrechen zu vereinzeln. Im weiteren Verlauf werden die vereinzelten, vorgesinterten Keramiklagen wie oben beschrieben zusammengesintert.

Alternativ dazu können Nutzen der vorgesinterten Keramiklagen zusammengesintert werden. Hier bietet sich an, die gleiche Stapelvorrichtung zu benutzen, die zur Herstellung der Keramiklagennutzen verwendet wird. Das Vereinzeln erfolgt erst nach dem Zusammensintern der Keramiklagen zu einem monolithischen Keramikkörper.

Das Sintern vereinzelter Keramiklagen hat aber den Vorteil, daß Schwindungstoleranzen und -inhomogenitäten wesentlich leichter aufgefangen werden. Außerdem ist es möglich, defekte Teile vor der Weiterverarbeitung auszusondern. Damit sind ein geringer Ausschuß und eine hohe Prozeßsicherheit verbunden.

Anhand eines Ausführungsbeispiels und der dazugehörigen Figuren wird im folgenden eine erfindungsgemäße Elektrodenanordnung und das Verfahren zu dessen Herstellung vorgestellt. Die Figuren stellen keine maßstabsgetreuen Abbildungen der bezeichneten Gegenstände dar.

Figur 1 zeigt eine erfindungsgemäße Vorrichtung im Querschnitt A-A.

Figur 2 zeigt eine erfindungsgemäße Vorrichtung von oben.

Figur 3 zeigt eine erfindungsgemäße Vorrichtung von unten.

Figur 4 zeigt eine erfindungsgemäße Vorrichtung im Querschnitt B-B.

Figur 5 zeigt ausgehend von der Herstellung einer Keramikgrünfolie die wesentlichen Verfahrensschritte zur Herstellung der Vorrichtung.

Figur 6 zeigt einen Keramikgrünfoliennutzen mit Lochstrukturen.

Figur 7 zeigt einen Keramikgrünfoliennutzen mit Metallisierungen.

Figur 8 zeigt in Draufsicht die Keramikgrünfolien im metallisierten Zustand, aus denen die Vorrichtung aufgebaut ist.

Figur 9 zeigt eine erfindungsgemäße Vorrichtung, die mit einer Kathode verbunden ist.

Gegenstand ist eine extrem kapazitätsarme Vorrichtung zur Formung eines Elektronenstrahls. Die Vorrichtung besteht aus einem keramischen Körper 11 mit monolithischem Vielschichtaufbau. Der Körper enthält eine Durchtrittsöffnung 12 für den Elektronenstrahl. Mit Hilfe von drei Gitterelektroden 141-143, die an der Durchtrittsöffnung angeordnet sind, wird die Vorrichtung in einer Schwarz-Weiß-Monitor-Röhre hoher Auflösung zur Intensitätsmodulierung und Fokussierung des Elektronenstrahls eingesetzt. Die Elektroden sind exakt koaxial zueinander angeordnet. Die Elektrodenabmessungen weisen Toleranzen von maximal ± 5 µm auf. Mit diesem Aufbau werden niedrige Kapazitäten bis herab zu 1 pF erreicht.

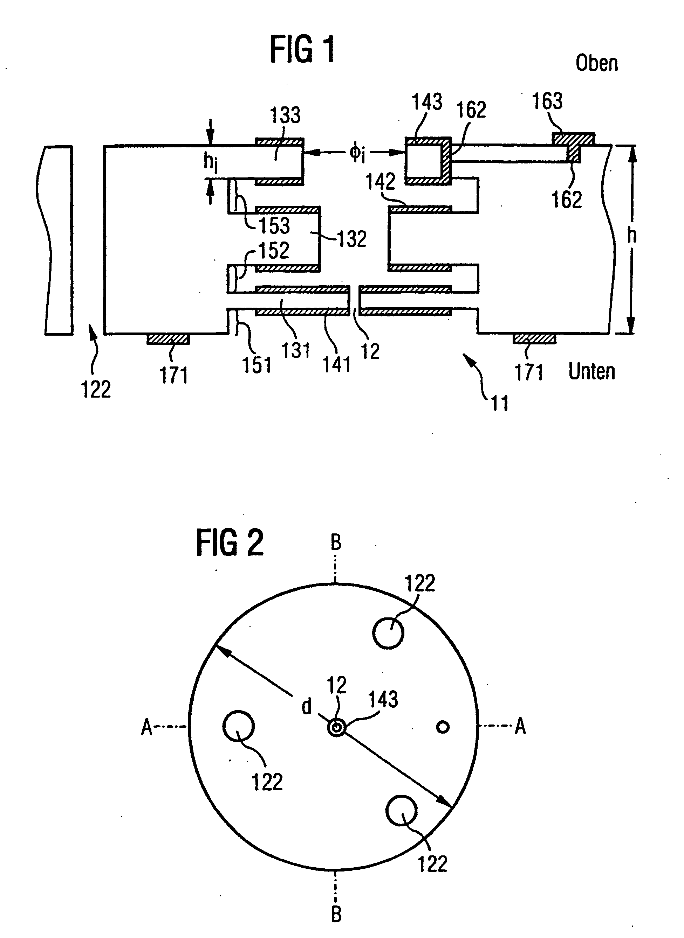

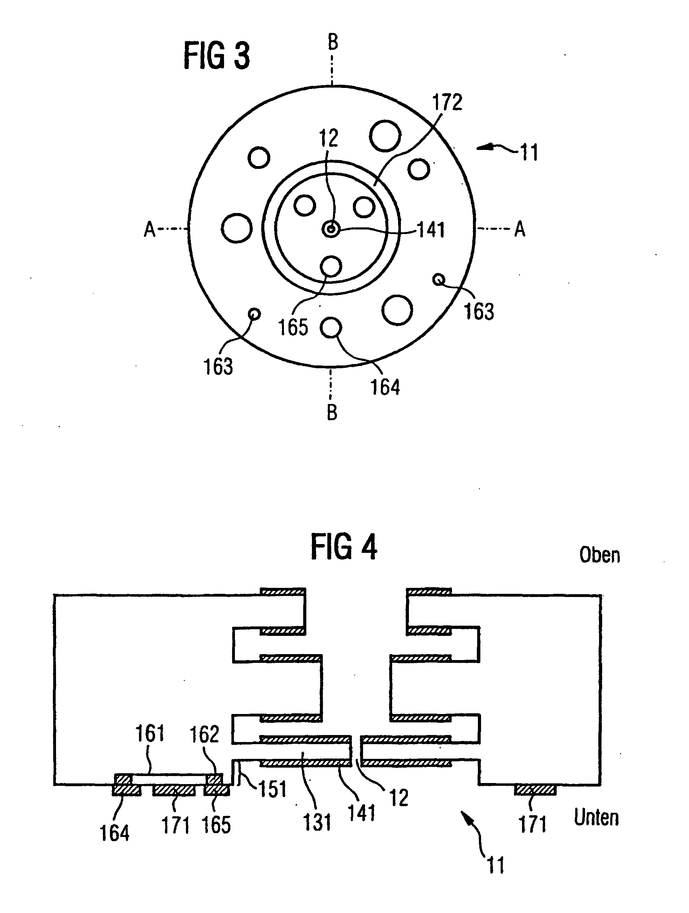

In Figur 1 ist die Vorrichtung im Querschnitt durch die Verbindungslinie A-A (siehe Figur 3) zu sehen. Figur 2 zeigt dieselbe Anordnung im Querschnitt durch die Verbindungslinie B-B. In den Figuren 3 und 4 ist die Anordnung von oben bzw. von unten zu sehen.

Die Vorrichtung ist im Ausführungsbeispiel als flacher, runder Zylinder geformt, der aus niedrigsinternder Glaskeramik besteht (Tₛ 850 - 950 °C). Der Durchmesser des Zylinders ist dabei wesentlich größer als seine Höhe (z.B. Höhe h = 985 µm; Durchmesser d = 1 - 3 cm).

Die Elektrodenanordnung weist einen monolithischen Vielschichtaufbau auf. Sie ist aus drei Isolierkeramiklagen 151-153 und drei Elektrodenkeramiklagen 131-133 aufgebaut. Elektrodenkeramiklagen und Isolierkeramiklagen sind in Ausbreitungsrichtung des Elektronenstrahls alternierend angeordnet.

Die Schichtdicken hᵢ der einzelnen Keramiklagen und die Durchmesser ⌀ᵢ der zugehörigen Durchtrittsöffnungen der Keramiklagen können beispielsweise Werte aufweisen, die in der folgenden Tabelle zusammengefaßt sind:

**Tabelle:**

| Schichtdicke hᵢ der Keramiklagen und Durchmesser ⌀ᵢ der Durchtrittsöffnung der Keramiklagen | | | | | | |
|---|---|---|---|---|---|---|
| Keramiklage | 151 | 131 | 152 | 132 | 153 | 133 |
| hᵢ[µm] | 100 | 50 | 190 | 300 | 165 | 180 |
| ⌀ᵢ[µm] | 1200 | 375 | 1200 | 500 | 1200 | 800 |

Jede Elektrodenkeramiklage verfügt direkt an der Durchtrittsöffnung über eine Elektrode. Dabei sind an der Ober- und Unterseite jeder Elektrodenkeramiklage Metallringe angebracht, die über eine vertikale elektrische Durchkontaktierung 162 miteinander elektrisch leitend verbunden sind. Die Durchmesser der Kontaktierungen betragen beispielsweise 300 µm. Die Elektroden sind als kreisrunde Ringe geformt. Der innere Durchmesser eines Rings entspricht dem Durchmesser des Keramikkörpers an der entsprechenden Stelle. Der äußere Durchmesser beträgt beispielsweise 1000 µm.

In einer besonderen Ausgestaltung der Erfindung sind die beiden Metallringe einer einzelnen Elektrodenkeramiklage elektrisch voneinander isoliert. Somit hat jede Elektrodenkeramiklage zwei Elektroden, die eine eigene elektrische Kontaktierung über eine Leiterbahn und/oder elektrische Durchkontaktierung aufweist.

Die Elektroden sind über horizontale elektrische Leiterbahnen 161 und damit verbunden vertikalen elektrischen Durchkontaktierungen 162 mit elektrischen Anschlußstellen 163 in Form von beispielsweise Lötpads verbunden, die sich an der Oberfläche der Elektrodenanordnung befinden. Die Leiterbahnen haben beispielsweise einen Durchmesser von 100 bis 200 µm.

Die drei Leiterbahnen, mit denen die Elektroden der drei Elektrodenkeramiklagen verbunden sind, sind möglichst entkoppelt. In Ausbreitungsrichtung des Elektronenstrahls betrachtet sind sie so angeordnet, daß sie nicht zur Deckung kommen. Die Leiterbahnen benachbarter Elektrodenkeramiklagen nehmen beispielsweise einen Winkel von 90° ein.

Drei elektrische Kontakte für die Ansteuerung einer Kathode sind ebenfalls in die Anordnung integriert in Form von Anschlußstellen 164 und 165 an der Unterseite, Durchkontaktierungen 162 und Leiterbahnen 161 in der untersten Isolierkeramiklage 151 (Figur 4).

Als Material für die Elektroden und die elektrischen Kontaktierungen kommen beispielsweise Gold, Kupfer, Molybdän, Palladium, Platin, Silber, beziehungsweise Legierungen der genannten Metalle in Frage.

Eine derartige Elektrodenanordnung kann in den Glaskörper einer Elektronenröhre eingeschmolzen werden. Besonders vorteilhaft ist es, die Elektrodenanordnung über einen Keramiksockel 91 mit einer Kathode 92 inklusive Heizungseinheit 93 zu verbinden (Figur 9). Die Kathode ist beispielsweise durch Laserschweißen an dem Keramiksockel 91 angebracht, der seinerseits über Glaslot 172 in Form eines Ringes mit der Elektrodenanordnung verbunden ist. Dabei ist sind die Einzelteile so zueinander angeordnet, daß die elektrischen Anschlüsse der Kathode mit den in der Elektrodenanordnung vorgesehenen Anschlußstellen 165 in Kontakt stehen. Damit wird die Kathode als Elektronenquelle über diese Anordnung gesteuert.

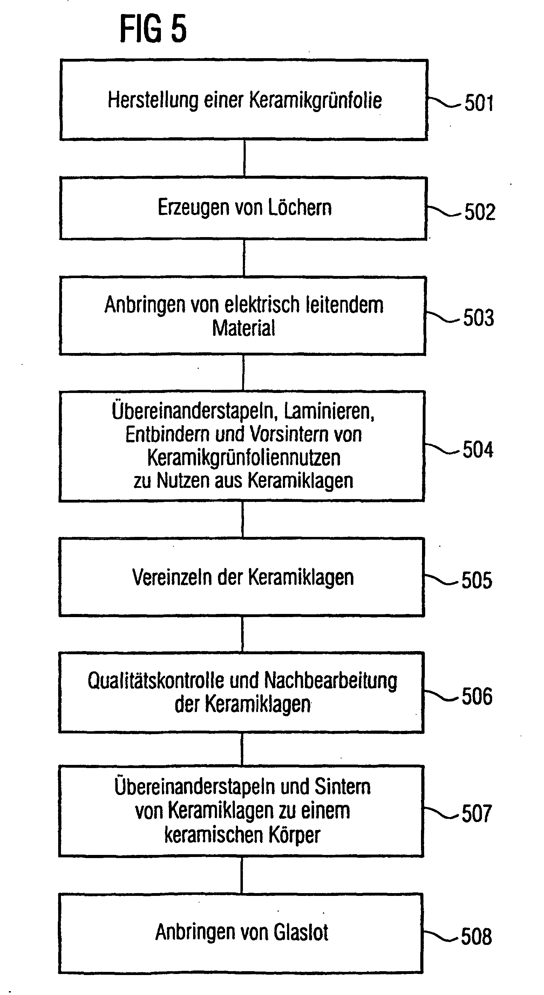

Die Herstellung einer zuvor beschriebenen Elektrodenanordnung in monolithischer Vielschichtbauweise erfolgt vorteilhaft im Nutzen. Anhand der Figur 5 sind die wesentlichen Verfahrensschritte sichtbar.

Zunächst wird eine einen organischen Binder enthaltende Keramikgrünfolie hergestellt (Prozeß 501). Das keramische Ausgangsmaterial aus Glaskeramik mit der gewünschten Zusammensetzung wird beispielsweise im Mixed-Oxide- oder Sol-Gel-Verfahren hergestellt. Zusammen mit dem organischen Binder und Wasser wird aus dem Ausgangsmaterial ein Schlicker hergestellt, aus dem die Keramikgrünfolie gezogen oder gegossen wird. Nach dem Trocknen weisen die Grünfolien eine Schichtdicke von beispielsweise 30 bis 300 µm auf.

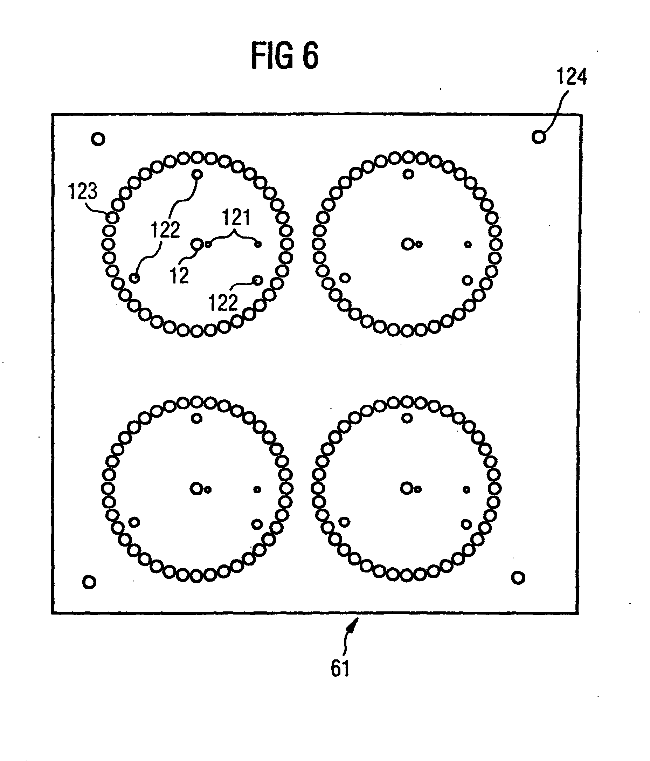

Im nächsten Verfahrensschritt 502 werden in der Keramikgrünfolie Löcher beispielsweise durch Stanzen erzeugt. Für einen 2x2-Nutzen 61 bedeutet das, daß vier identische Löcherkombinationen in der Grünfolie erzeugt werden (Figur 6). Eine Löcherkombinationen enthält eine Durchtrittsöffnung 12, durch die der Elektronenstrahl geführt werden soll, Öffnungen 121 , mit denen Durchkontaktierungen 162 hergestellt werden, Zentrierlöcher 122 und eine Lochreihe 123, die die Vereinzelung der aus der Keramikgrünfolie herzustellenden Keramiklage ermöglicht. In der Keramikgrünfolie werden zudem Zentrierlöcher 124 erzeugt, mit deren Hilfe Keramikgrünfolien im Nutzen übereinander gestapelt werden. Figur 6 zeigt beispielhaft einen Grünfoliennutzen mit Lochstrukturen, der in der Herstellung der Elektrodenkeramiklage 132 benötigt wird.

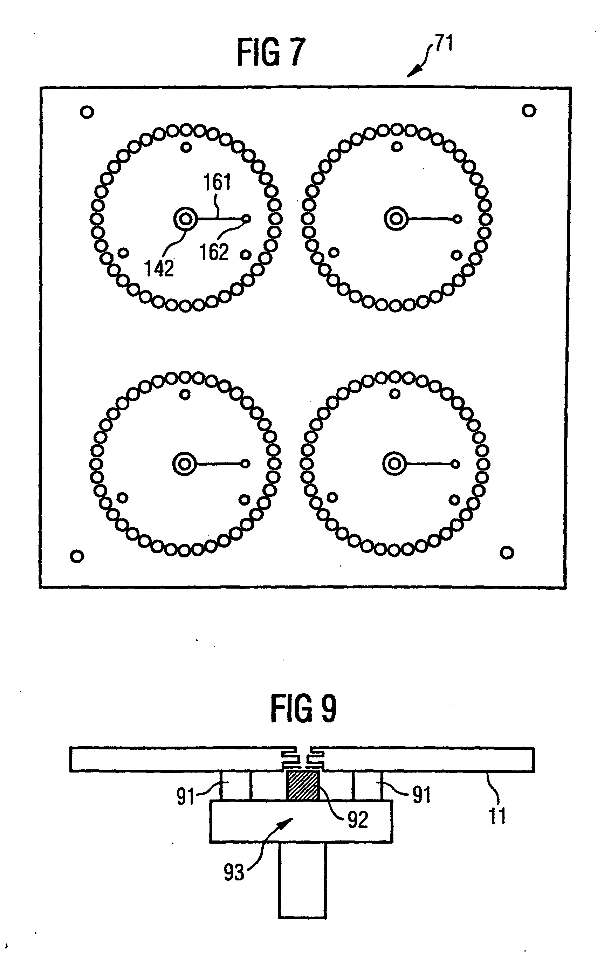

Im nächsten Schritt 503 werden Elektroden und/oder elektrische Leiterstrukturen beispielsweise im Siebdruckverfahren auf die Keramikgrünfolie aufgedruckt. Es werden z.B. Leiterbahnen 161 von 100 µm hergestellt. Die Elektroden an den vier Durchtrittsöffnungen des Nutzens werden in Form von Ringen aufgetragen (Figur 7).

Sofern Löcher für elektrische Durchkontaktierungen vorhanden sind, werden diese beispielsweise im Schablonendruckverfahren mit elektrisch leitendem Material befüllt. Schablonen- und Siebdruck können beispielsweise mit derselben Vorrichtung durchgeführt werden. Figur 7 zeigt den Nutzen aus Figur 6 nach den Metallisierungsschritten.

In der darauffolgenden Phase (504) werden entsprechend der Funktionalität der herzustellenden Keramiklage Keramikgrünfolien im Nutzen übereinander gestapelt und unter einachsigem Druck oder isostatisch zu einem Verbundnutzen laminiert. Durch beispielsweise langsame Erhöhung der Temperatur auf 500 °C wird der Verbund vom Binder befreit und zu Nutzen von Keramiklagen vorgesintert. Nach der Entbinderung findet das Vorsintern des Verbundes zu einer Keramiklage statt. Die Sintertemperatur Tₛ liegt beispielsweise 100 K unter der Sintertemperatur der verwendeten Glaskeramik. Die Sinterunterlage beim Vorsintern ist vorzugsweise aus Siliziumkarbid.

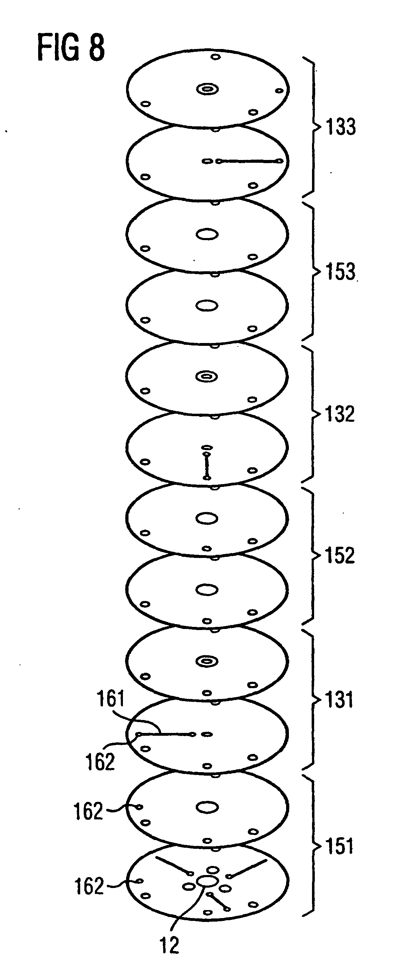

Die Elektrodenkeramiklage 132 ist beispielsweise aus zwei Keramikgrünfolien aufgebaut. Dementsprechend werden Nutzen der jeweiligen Keramikgrünfolien übereinandergestapelt (Figur 8). Das Übereinanderstapeln richtet sich nach den Zentrierlöchern, wobei die Loch- und Leiterstrukturen in den Keramikgrünfolien so angebracht sind, daß beim Übereinanderstapeln und nachfolgenden Laminieren und Sintern die gewünschten dreidimensionalen Strukturen entstehen (z.B. elektrische Durchkontaktierungen).

Nach dem Vorsintern werden die Keramiklagen vereinzelt (505). Mit Hilfe der Lochstrukturen 123 gelingt dies einfach durch Herausbrechen einer Keramiklage aus dem Keramiklagennutzen.

Nach diesem Schritt können die vereinzelten Keramiklagen einer Qualitätskontrolle 506 unterzogen werden. Schadhafte Keramiklagen können aussortiert werden, oder aber wenn geforderte Fehlertoleranzen eingehalten werden eventuell nachbearbeitet werden. Das Nachbearbeiten betrifft in erster Linie das Nachbessern der Elektrodenöffnung (beispielsweise durch Schleifen, Laserbohren) und das Abschleifen der Oberfläche der Keramiklage. Dadurch erhält man planparallele Flächen der Ober- und Unterseite der Keramiklagen. Die Keramiklage zeichnet sich dann durch eine definierte Schichtdicke aus. Das Nacharbeiten kann beispielsweise auch das Abschleifen der Mantelfläche des Keramikkörpers beinhalten.

Unter Verwendung einer zweiten Stapelvorrichtung werden nun die vereinzelten Keramiklagen übereinandergestapelt und unter Druck bei der Sintertemperatur Tₛ der Glaskeramik unter einachsigem Druck zu der Elektrodenanordnung mit monolithischem Vielschichtaufbau zusammengesintert (507).

Um die Elektrodenanordnung mit anderem keramischen Material z.B. dem Keramiksockel einer Kathode zu verbinden, wird vorzugsweise im Siebdruckverfahren Glaslot 172 auf der Unterseite der Elektrodenanordnung vorzugsweise in Form eines Ringes angebracht (508).

Figur 8 zeigt im Überblick den Schichtaufbau der Elektrodenanordnung 11 aus einzelnen Keramikgrünfolien. Die Keramikgrünfolien sind im Zustand nach dem Anbringen von Metallisierungen gezeigt. Jeweils zwei Keramikgrünfolien bilden eine Keramiklage. Dies trifft auch auf die Isolierkeramiklagen zu. Durch den zweischichtigen Aufbau wird die Planarisierung dieser Keramiklagen erheblich verbessert und damit die koaxiale Ausrichtung der Durchtrittsöffnungen der Elektrodenkeramiklagen stark vereinfacht. Durch die Orientierung der Leiterbahnen zueinander wird eine extrem kapazitätsarme Vorrichtung erhalten.

## Patentansprüche

1. Vorrichtung zur Formung eines Elektronenstrahls, bestehend aus einem keramischen Körper in monolithischer Vielschichtaufbauweise (11) mit
- mindestens zwei Elektrodenkeramiklagen (131, 132, 133), die jeweils mindestens eine Durchtrittsöffnung für den Elektronenstrahl und jeweils mindestens eine an der Durchtrittsöffnung (12) angeordnete Elektrode (141, 142, 143) mit elektrischer Kontaktierung (161, 162) aufweisen, und
- mindestens einer Isolierkeramiklage (152, 153), die eine Durchtrittsöffnung (12) für den Elektronenstrahl aufweist und die zur Isolierung der Elektrodenkeramiklagen (131, 132, 133) zwischen den Elektrodenkeramiklagen (131, 132, 133) angeordnet ist, wobei
- die Elektrodenkeramiklagen (131, 132, 133) und die Isolierkeramiklage (152, 153) entlang einer Ausbreitungsrichtung des Elektronenstrahls derart angeordnet sind, dass die Durchtrittsöffnungen der Elektrodenkeramiklagen (131, 132, 133) und der Isolierkeramiklage (152, 153) eine gemeinsame Durchtrittsöffnung (12) bilden,
**dadurch gekennzeichnet, daß**
- die Elektrodenkeramiklagen (131, 132, 133) und die Isolierkeramiklage (152, 153) eine Glaskeramik mit einer aus dem Bereich von einschließlich 6 bis einschließlich 8 ausgewählten relativen Dielektrizitätskonstante aufweisen,
- die Elektroden (141, 142, 143) um die Durchtrittsöffnung angeordnete Ringelektroden sind und
- die Elektroden (141, 142, 143) und die elektrischen Kontaktierungen (161, 162) der Elektrodenkeramiklagen aus einem elementaren Metall sind.

2. Vorrichtung nach Anspruch 1, wobei zumindest zwei Elektroden zumindest einer der Elektrodenkeramiklagen entlang der Ausbreitungsrichtung des Elektronenstrahls nacheinander angeordnet sind.

3. Vorrichtung nach einem der Anspruch 2, wobei die Elektroden der Elektrodenkeramiklage elektrisch voneinander isoliert sind.

4. Vorrichtung nach einem der Anspruch 2, wobei die Elektroden der Elektrodenkeramiklage miteinander elektrisch leitend verbunden sind.

5. Vorrichtung nach einem der Ansprüche 1 bis 4, wobei das Metall zumindest einen Stoff aus der Gruppe Gold, Kupfer, Molybdän, Palladium, Platin, Silber und/oder Wolfram aufweist.

6. Vorrichtung nach einem der Ansprüche 1 bis 5, wobei mehrere Elektroden und elektrischen Kontaktierungen so angeordnet sind, daß eine Kapazitätsanordnung gebildet wird, deren Kapazitäten unter 3 pF liegen.

7. Vorrichtung nach einem der Ansprüche 1 bis 6, wobei der Körper mittels Glaslot mit einer Kathode zur Erzeugung des Elektronenstrahls verbunden ist.

8. Verwendung einer Vorrichtung nach einem der Ansprüche 1 bis 7 zur Intensitätsmodulierung und Fokussierung des Elektronenstrahls.

9. Verfahren zur Herstellung einer Vorrichtung nach einem der Ansprüche 1 bis 7, bei dem
a) aus zumindest einer einen Binder enthaltenden Keramikgrünfolie zumindest drei Keramiklagen mit jeweils mindestens einer Durchtrittsöffnung für den Elektronenstrahl gefertigt werden, wobei zumindest zwei der Keramiklagen als Elektrodenkeramiklagen und mindestens eine der Keramiklagen als Isolierkeramiklage ausgestaltet werden,
b) die Keramiklagen unter Verwendung einer ersten Stapelvorrichtung so gestapelt wird, daß die Durchtrittsöffnungen der Keramiklagen übereinander angeordnet sind, und
c) die Keramiklagen unter einachsigem Druck bei der Sintertemperatur des verwendeten Keramikmaterials zu dem Körper (11) gesintert werden.

10. Verfahren nach Anspruch 9, wobei zur Fertigung einer der Keramiklagen
a) in der Keramikgrünfolie mindestens eine Durchtrittsöffnung (12) erzeugt wird,
b) mindestens zwei der Keramikgrünfolien unter Verwendung einer zweiten Stapelvorrichtung so gestapelt werden, daß die Durchtrittsöffnungen übereinander angeordnet sind,
c) die gestapelten Keramikgrünfolien zu einem Verbund laminiert werden,
d) der Verbund bei erhöhter Temperatur vom Binder befreit wird und
e) der Verbund bei einer Temperatur zur Keramiklage vorgesintert wird, die unter der Sintertemperatur des verwendeten Keramikmaterials liegt.

11. Verfahren nach Anspruch 9 oder 10, wobei das Verfahren zur Fertigung der Keramiklage die Herstellung einer elektrischen Durchkontaktierung (162) in der Keramiklage beinhaltet, wobei
a) in mindestens einer der Keramikgrünfolien mindestens eine Kontaktierungsöffnung (121) erzeugt wird, die
b) mit elektrisch leitendem Material befüllt wird.

12. Verfahren nach Anspruch 10 oder 11, wobei zur Fertigung einer Elektrodenkeramiklage nach dem Vorsintern auf einer Oberfläche der Elektrodenkeramiklage elektrisch leitendes Material angebracht wird.

13. Verfahren nach einem der Ansprüche 9 bis 12, wobei zur Fertigung einer Elektrodenkeramiklage auf der Oberfläche mindestens einer Keramikgrünfolie elektrisch leitendes Material angebracht wird.

14. Verfahren nach einem der Ansprüche 11 bis 13, wobei als elektrisch leitendes Material zumindest ein Stoff aus der Gruppe Gold, Kupfer, Molybdän, Palladium, Platin, Silber und/oder Wolfram ausgewählt wird.

15. Verfahren nach einem der Ansprüche 9 bis 18, wobei zur Herstellung zumindest einer der Keramiklagen
a) die Keramikgrünfolien so übereinander gestapelt werden, daß die oberste und die unterste Keramikgrünfolie des Verbundes Keramikmaterial aufweisen, dessen Sintertemperatur über der des Keramikmaterials liegt, das die im Verbund dazwischen liegenden Keramikgrünfolien aufweisen, und
b) nach dem Vorsintern das höher sinternde Keramikmaterial entfernt wird.

16. Verfahren nach Anspruch 16, wobei beim Stapeln als oberste und unterste Keramikgrünfolie jeweils eine Keramikgrünfolie verwendet wird, die Aluminiumoxid aufweist.

## Claims

1. Device for shaping an electron beam, comprising a ceramic body of monolithic multilayer structure (11) having
- at least two electrode individual ceramic layers (131, 132, 133), which each have at least one passage opening for the electron beam and each have at least one electrode (141, 142, 143), arranged at the passage opening (12), with electrical contact-making features (161, 162), and
- at least one insulating individual ceramic layer (152, 153), which has a passage opening (12) for the electron beam and in order to insulate the electrode individual ceramic layers (131, 132, 133) is arranged between the electrode individual ceramic layers (131, 132, 133), wherein
- the electrode individual ceramic layers (131, 132, 133) and the insulating individual ceramic layer (152, 153) are arranged along a propagation direction of the electron beam in such a manner, that the passage openings in the electrode individual ceramic layers (131, 132, 133) and in the insulating individual ceramic layer (152, 153) form a common passage opening (12),
**characterized in that**
- the electrode individual ceramic layers (131, 132, 133) and the insulating individual ceramic layer (152, 153) include a glass-ceramic having a relative permittivity which is selected from the range from 6 to 8 inclusive,
- the electrodes (141, 142, 143) are ring electrodes arranged around the passage opening, and
- the electrodes (141, 142, 143) and the electrical contact-making features (161, 162) of the electrode individual ceramic layers are made from an elemental metal.

2. Device according to Claim 1, in which at least two electrodes of at least one of the electrode individual ceramic layers are arranged in succession along the propagation direction of the electron beam.

3. Device according to Claim 2, in which the electrodes of the electrode individual ceramic layer are electrically insulated from one another.

4. Device according to Claim 2, in which the electrodes of the electrode individual ceramic layer are electrically conductively connected to one another.

5. Device according to one of Claims 1 to 4, in which the metal includes at least one substance selected from the group consisting of gold, copper, molybdenum, palladium, platinum, silver and/or tungsten.

6. Device according to one of Claims 1 to 5, in which a plurality of electrodes and electrical contact-making features are arranged in such a way as to form a capacitor arrangement with capacitances of below 3 pF.

7. Device according to one of Claims 1 to 6, in which the body is joined to a cathode for generating the electron beam by means of soldering glass.

8. Use of a device according to one of Claims 1 to 7 for modulating the intensity of and focusing the electron beam.

9. Process for producing a device according to one of Claims 1 to 7, in which
a) at least three individual ceramic layers, each having at least one passage opening for the electron beam, are manufactured from at least one ceramic green sheet which contains a binder, at least two of the individual ceramic layers being configured as electrode individual ceramic layers and at least one of the individual ceramic layers being configured as an insulating individual ceramic layer,
b) the individual ceramic layers being stacked using a first stacking device in such a way that the passage openings in the individual ceramic layers are arranged above one another, and
c) the individual ceramic layers being sintered under uniaxial pressure at the sintering temperature of the ceramic material used, to form the body (11).

10. Process according to Claim 9, in which, to manufacture one of the individual ceramic layers,
a) at least one passage opening (12) is produced in the ceramic green sheet,
b) at least two of the ceramic green sheets are stacked using a second stacking device, in such a way that the passage openings are arranged above one another,
c) the stacked ceramic green sheets are laminated to form an assembly,
d) the binder is removed from the assembly at elevated temperature, and
e) the assembly is pre-sintered to form the individual ceramic layer at a temperature which is below the sintering temperature of the ceramic material used.

11. Process according to Claim 9 or 10, in which the process for manufacturing the individual ceramic layer includes the production of an electrical through-contact-making feature (162) in the individual ceramic layer, wherein
a) at least one contact-making opening (121) is produced in at least one of the ceramic green sheets and
b) is filled with electrically conductive material.

12. Process according to Claim 10 or 11, in which, to manufacture an electrode individual ceramic layer, after the pre-sintering operation, electrically conductive material is applied to a surface of the electrode individual ceramic layer.

13. Process according to one of Claims 9 to 12, in which, to manufacture an electrode individual ceramic layer, electrically conductive material is applied to the surface of at least one ceramic green sheet.

14. Process according to one of Claims 11 to 13, in which the electrically conductive material selected is at least one substance selected from the group consisting of gold, copper, molybdenum, palladium, platinum, silver and/or tungsten.

15. Process according to one of Claims 9 to 18, in which, to produce at least one of the individual ceramic layers,
a) the ceramic green sheets are stacked on top of one another in such a way that the top and bottom ceramic green sheets of the assembly contain ceramic material whose sintering temperature is higher than that of the ceramic material contained by the ceramic green sheets which lie between them in the assembly, and
b) the ceramic material which sinters at a higher sintering temperature is removed after the pre-sintering operation.

16. Process according to Claim 15, in which, during the stacking operation, a ceramic green sheet which contains aluminium oxide is in each case used as the top and bottom ceramic green sheets.

## Revendications

1. Dispositif destiné à former un faisceau d'électrons, constitué d'un corps en céramique de structure monolithique multicouche (11) avec
- au moins deux couches de céramique à électrodes (131, 132, 133), présentant chacune au moins un orifice de passage pour le faisceau d'électrons et chacune au moins une électrode (141, 142, 143) disposée sur l'orifice de passage (12), avec une connexion électrique (161, 162)
et
- au moins une couche de céramique isolante (152, 153), présentant un orifice de passage (12) pour le faisceau d'électrons et disposée entre les couches de céramique à électrodes (131, 132, 133), pour l'isolation des couches de céramique à électrodes (131, 132, 133),
- les couches de céramique à électrodes (131, 132, 133) et la couche de céramique isolante (152, 153) étant disposées le long d'un sens de propagation du faisceau d'électrons, de manière à ce que les orifices de passage des couches de céramique à électrodes (131, 132, 133) et la couche de céramique isolante (152, 153) forment un orifice de passage commun (12),
**caractérisé en ce que**
les couches d'électrons en céramique (131, 132, 133) et la couche en céramique isolante (152, 153) présentent une vitrocéramique avec une constante diélectrique relative, située dans la plage entre 6 indus et 8 inclus,
- les électrodes (141, 142, 143) sont des électrodes annulaires disposées autour de l'orifice de passage et
- les électrodes (141, 142, 143) et les connexions électriques (161, 162) des couches de céramique à électrodes sont réalisées dans un métal élémentaire.

2. Dispositif selon la revendication 1,
au moins deux électrodes d'au moins l'une des couches de céramique à électrodes étant disposées l'une derrière l'autre, le long du sens de propagation du faisceau d'électrons.

3. Dispositif selon la revendication 2,
les électrodes de la couche de céramique à électrodes étant électriquement isolées l'une par rapport à l'autre.

4. Dispositif selon la revendication 2,
les électrodes de la couche de céramique à électrodes étant reliées entre elles de manière à conduire l'électricité.

5. Dispositif selon l'une quelconque des revendications 1 à 4,
le métal étant au moins une substance issue du groupe contenant l'or, le cuivre, le molybdène, le palladium, le platine, l'argent et/ou le tungstène.

6. Dispositif selon l'une quelconque des revendications 1 à 5,
plusieurs électrodes et connexions électriques étant disposées de manière à former une configuration de capacité, dont la capacité est inférieure à 3pF.

7. Dispositif selon l'une quelconque des revendications 1 à 6,
le corps étant relié par soudure au verre avec une cathode destinée à générer le faisceau d'électrons.

8. Utilisation d'un dispositif selon l'une quelconque des revendications 1 à 7,
pour la modulation d'intensité et la focalisation du faisceau d'électrons.

9. Procédé de fabrication d'un dispositif selon l'une quelconque des revendications 1 à 7, dans lequel
a) à partir d'au moins un film vert en céramique contenant au moins un liant, au moins trois couches de céramique présentant chacune au moins un orifice de passage pour le faisceau d'électrons sont fabriquées, au moins deux des couches en céramique étant conçues sous forme de couches en céramique à électrodes et au moins l'une des couches en céramique étant conçue sous forme de couche en céramique isolante,
b) en utilisant un premier dispositif d'empilage, les couches en céramique sont empilées de manière à ce que les orifices de passage des couches en céramique soient disposés les uns au-dessus des autres et
c) les couches en céramique sont frittées vers le corps (11), sous pression mono axiale, à la température de frittage du matériau céramique utilisé.

10. Procédé selon la revendication 9, pour la fabrication de l'une des couches en céramique
a) au moins un orifice de passage (12) étant crée dans le film vert en céramique,
b) en utilisant un second dispositif d'empilage, au moins deux des films verts en céramique étant empilés de manière à ce que les orifices de passage soient empilés les uns sur les autres,
c) les films verts en céramique empilés étant laminés en un composite,
d) le composite étant libéré du liant sous température élevée, et
e) le composite étant préfritté en une couche en céramique, à une température inférieure à la température de frittage du matériau céramique utilisé.

11. Procédé selon l'une quelconque des revendications 9 ou 10,
le procédé de fabrication de la couche en céramique incluant la fabrication d'une connexion électrique transversale (162) dans la couche en céramique,
a) dans au moins l'un des films verts en céramique, au moins un orifice de contact (121) étant créé, lequel
b) est rempli d'une matière conductrice d'électricité.

12. Procédé selon l'une quelconque des revendications 10 ou 11,
pour la fabrication d'une couche en céramique à électrodes, après le préfrittage, une matière conductrice d'électricité étant appliquée sur une couche en céramique à électrodes.

13. Procédé selon l'une quelconque des revendications 9 à 12,
pour la fabrication d'une couche en céramique à électrodes, une matière conductrice d'électricité étant appliquée sur la surface d'au moins un film vert en céramique.

14. Procédé selon l'une quelconque des revendications 11 à 13,
au moins une substance issue du groupe contentant l'or, le cuivre, le molybdène, le palladium, le platine, l'argent et/ou le tungstène étant sélectionnée en tant que matière conductrice d'électricité.

15. Procédé selon l'une quelconque des revendications 9 à 18,
pour la fabrication d'au moins l'une des couches en céramique
a) les couches en céramique étant empilées les unes sur les autres de manière à ce qu'au moins le film vert en céramique inférieur et supérieur du composite présentent de la matière céramique, dont la température de frittage est supérieure à la température de frittage de la matière céramique, dont sont munies les films en céramique situés dans le composite et
b) après le préfrittage, le matériel céramique à température de frittage plus élevée étant éliminé.

16. Procédé selon la revendication 16,
lors de l'empilage, un film vert en céramique présentant de l'oxyde d'aluminium étant utilisé en tant que film vert en céramique supérieur et inférieur.
